# EUROPEAN PATENT APPLICATION

(11) **EP 1 741 803 A2**
(43) Date of publication of application: **10.01.2007**
(21) Application number: 06014078.7
(22) Date of filing: 06.07.2006
(51) Int. Cl.: C23C 16/44

(54) **Free radical initiator in remote plasma chamber clean**

(30) Priority: 08.07.2005 US 177078
(71) Applicant: Air Products and Chemicals, Inc., Allentown, PA 18195-1501 (US)
(72) Inventor: Ji, Bing, Pleasanton CA 94566 (US)
(74) Representative: Kador & Partner

(57) **Abstract**

This invention relates to an improvement in the remote plasma cleaning of CVD process chambers and equipment from unwanted deposition byproducts formed on the walls, surfaces, etc. of such deposition process chambers and equipment. The improvement in the remote cleaning process resides in providing a free radical initiator downstream of the remote plasma generator employed for producing said plasma, said free radical initiator capable of forming free radicals in the presence of said plasma.

## Description

### BACKGROUND OF THE INVENTION

In the electronics industry, various film deposition techniques have been developed wherein selected materials are deposited on a target substrate to produce electronic components such as semiconductors. One type of film deposition process includes chemical vapor deposition (CVD) wherein gaseous reactants are introduced into a heated processing chamber, vaporized and films formed on the desired substrate. Other types of film deposition processes include plasma enhanced chemical vapor deposition (PECVD), and alternate vapor deposition (ALD).

Generally, all methods of film deposition result in the accumulation of unwanted films and particulate materials on surfaces other than the target substrate, that is, the deposition materials also collect on the walls, tool surfaces, susceptors, and on other equipment employed in the deposition process. These unwanted solid residues can change the reactor surface characteristics and RF power coupling efficiency as well as lead to deposition process performance drifts, and loss of production yield. Moreover, accumulated solid residues also can flake off from the deposition reactor internal surface, and deposit onto a wafer surface causing device defects.

It is well accepted that deposition chambers and equipment must be periodically cleaned to remove unwanted contaminating deposition materials and prevent the problems associated therewith. This kind of cleaning operation is often called chamber cleaning. A generally preferred method of cleaning deposition tools involves the use of perfluorinated compounds (PFC's), e.g., C₂F₆, CF₄, C₃F₈, C₄F₈, SF₆, and NF₃ as cleaning agents. These species react with the unwanted film deposition products on the CVD chamber walls and other equipment and form gaseous residues, i.e., volatile species. The gaseous residue then is swept from the processing chamber.

Plasma cleaning of unwanted deposition residues is an accepted commercial process. There are two ways to achieve plasma activation: remote plasma clean and *in situ* plasma clean. In *in situ* plasma clean, fluoro-compound plasmas are generated inside the same CVD reactor. In remote plasma clean, the plasma chamber is outside of the CVD reactor. Remote plasma chamber cleaning offers several distinct advantages: lower CVD reactor damage, higher feed gas destruction efficiency, shorter clean time and higher production throughput. Also, it is well suited for cleaning reactor systems designed for low temperature film deposition and in those instances where *in situ* plasma cleaning results in excessive etching of surfaces in process equipment.

One of the problems of remote plasma cleaning resides in the fact that a large part of the free radicals formed in the plasma generator recombine into an inert form by the time they reach the process chamber. Therefore, a substantial portion of the reactant gas is wasted resulting in low utilization efficiency.

The following references are illustrative of processes for the deposition of films in semiconductor manufacture and the cleaning of deposition chambers:

US 5,421,957 discloses a process for the low temperature cleaning of cold-wall CVD chambers. The process is carried out, *in situ,* under moisture free conditions. Cleaning of films of various materials such as epitaxial silicon, polysilicon, silicon nitride, silicon oxide, and refractory metals, titanium, tungsten and their silicides is effected using an etchant gas, e.g., nitrogen trifluoride, chlorine trifluoride, sulfur hexafluoride, and carbon tetrafluoride. NF₃ etching of chamber walls thermally at temperatures of 400-600 °C is shown.

US 5,043,299 discloses a process for the selective deposition of tungsten on a masked semiconductor, cleaning the surface of the wafer and transferring to a clean vacuum deposition chamber. In the selective tungsten CVD process, the wafer, and base or susceptor is maintained at a temperature from 350 to 500 °C when using H₂ as the reducing gas and from 200 to 400 °C when using SiH₄ as the reducing gas. A halogen containing gas, e.g., BCl₃ is used for cleaning aluminum oxide surfaces on the wafer and NF₃ or SF₆ are used for cleaning silicon oxides. Also disclosed is a process for cleaning CVD chambers using NF₃ plasma followed by an H₂ plasma.

GB 2,183,204 A discloses the use of NF₃ for the *in situ* cleaning of CVD deposition hardware, boats, tubes, and quartz ware as well as semiconductor wafers. NF₃ is introduced to a heated reactor in excess of 350 °C for a time sufficient to remove silicon nitride, polycrystalline silicon, titanium silicide, tungsten silicide, refractory metals and silicides.

US 6,439,155, US 6,263,830 and US 6,352,050 (division of '830) disclose a remote plasma generator, coupling microwave frequency energy to a gas and delivering radicals to a downstream process chamber. More efficient delivery of oxygen and fluorine radicals is effected by the use of a one-piece sapphire transport tube to minimize recombination of radicals in route to the process chamber. In one embodiment fluorine and oxygen radicals are separately generated and mixed upstream of the process chamber.

WO 99/02754 discloses a method and apparatus for cleaning a chamber employed in semiconductor processing. A diluent gas is mixed with a flow of radicals produced by a plasma generator remotely disposed to the processing chamber. The presence of the inert gas in the delivered plasma results in less destruction of the chamber walls and surfaces.

US 20004/0115936 discloses apparatus for the fabrication of semiconductor devices, including formation of dielectric films, photoresist stripping and wafer and chamber cleaning.

### SUMMARY OF THE INVENTION

This invention relates to an improvement in the remote plasma cleaning of CVD process chambers and equipment from unwanted deposition byproducts formed on the walls, surfaces, etc. of such deposition process chambers and equipment. In a remote plasma cleaning process, a reactant is charged to a plasma generator and a plasma of free radicals is formed from the reactant. The plasma is delivered to the CVD process chamber downstream of the plasma generator. The improvement in the remote cleaning process resides in delivering a free radical initiator to the CVD process chamber, said free radical initiator capable of forming free radicals in the presence of said plasma. Typically, the free radical initiator is combined with the plasma and the combination delivered to the CVD chamber.

Several advantages can be achieved through the process described here and some of these include:
an ability to reduce the cleaning time through optimization of a reduced temperature chamber clean;
an ability to enhance the remote plasma cleaning of semiconductor deposition process chambers by using free radical initiators to suppress the recombination of free radicals formed in the plasma generator prior to reaction with the unwanted residue;
an ability to minimize free radical recombination, e.g., fluorine atom recombination, prior to reaction with unwanted residue in the deposition process chamber and thereby increase the efficiency of reactant utilization and efficiency of chamber cleaning; and,
an ability to reduce reactant emission from the effluent from the deposition process chamber, and thereby reduce the load and cost of reactant abatement and minimize toxic gas emissions.

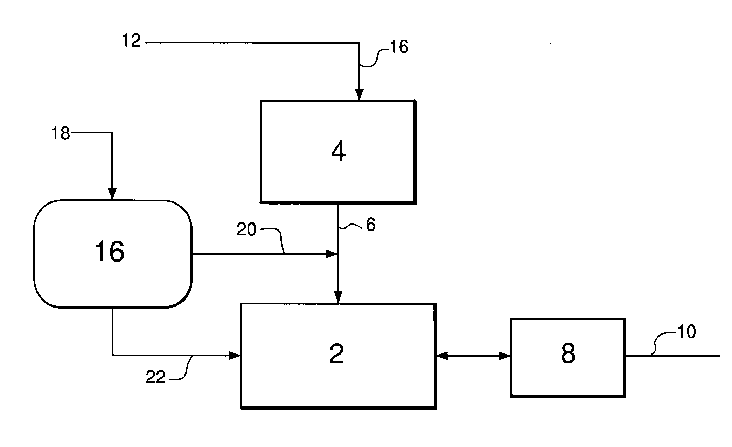

### BRIEF DESCRIPTION OF THE DRAWING

The drawing is a schematic illustration of a preferred embodiment of the present invention.

### DETAILED DESCRIPTION OF THE INVENTION

In the manufacture of semiconductor integrated circuits (IC), optoelectronic devices, and microelectro-mechanical systems (MEMS), multiple steps of thin film deposition are performed in order to construct several complete circuits (chips) and devices on monolithic substrate wafers. Each wafer is often deposited with a variety of thin films: conductor films, such as tungsten; semiconductor films such as undoped and doped poly-crystalline silicon (poly-Si), doped and undoped (intrinsic) amorphous silicon (a-Si); dielectric films such as silicon dioxide (SiO₂), undoped silicon glass (USG), boron doped silicon glass (BSG), phosphorus doped silicon glass (PSG), and borophosphorosilicate glass (BPSG), silicon nitride (Si₃N₄), silicon oxynitride (SiON) etc.; low-k dielectric films such as fluorine doped silicate glass (FSG), and carbon-doped silicon glass (CDSG), such as "Black Diamond". Thin film deposition can be accomplished by placing the substrate (wafer) into an evacuated process chamber, and introducing gases that undergo chemical reactions to deposit solid materials onto the wafer surface. Such a deposition process is called chemical vapor deposition (CVD) and included variations such as atomic layer deposition (ALD) and plasma enhanced chemical vapor deposition (PECVD).

As stated previously, unwanted deposition products are formed on the wall surfaces as well as other equipment present in the deposition process chamber. The use of remote plasma cleaning of CVD process chambers for semiconductor fabrication and equipment parts employed therein has been employed with success. In the cleaning process, a flow of a reactant suited for producing free radicals capable of reacting with the unwanted deposit is charged to a plasma generator. In the plasma generator, free radicals are created from the reactant supplied thereto and the free radical containing plasma delivered to the site to be cleaned. A flow rate of reactant of from about 100 - 5000 sccm to the plasma generator is common.

Reactants in the gaseous form are commonly used in a remote plasma cleaning process although other forms of precursor compounds from which free radicals can be created, e.g., solids and liquids may be used. Conventional reactants for remote plasma cleaning are halogen containing compounds and generally compounds containing fluorine. Such fluorine compounds readily create reactive free radicals (e.g., F•) in the plasma generator and thus are well suited for cleaning. Exemplary reactant compounds include PFC's such as fluorine, nitrogen trifluoride, tetrafluoromethane, hexafluoroethane, octafluoropropane, octafluoro-cyclobutane, sulfur hexafluoride, oxydifluoride, and chlorotrifluoride.

Illustrative mechanisms for cleaning tungsten, silicon, and silicon dioxide residues using a fluorine containing reactant are shown by the following reactions, respectively:

W(s) + 6 F• → WF₆(*g*)

Si(s) + 4 F• → SiF₄(*g*)

SiO₂(*s*) + 4 F• → SiF₄(*g*) + O₂(*g*)

Among the fluorine containing compounds used in remote plasma chamber cleaning processes, NF₃ is the most widely used. With adequate power, NF₃ is nearly completely dissociated in a plasma generator and a large amount of fluorine atoms or free radicals (F•) are transported into the downstream CVD or deposition process chamber for effecting removal of the unwanted residue. The conversion of NF₃ to a reactive free radical form is illustrated by the equation 2NF₃ → N₂ + 6F•.

A significant portion of the free radicals formed in the plasma generator, and particularly fluorine atoms (F•), recombine during the delivery of the fluorine atoms or transportation of the fluorine atoms to the site of cleaning from the remote plasma generator to the CVD process chamber, or inside the CVD process chamber. This is shown by the equation: F• + F• → F₂.

The recombined molecules, such as the fluorine molecules (F₂), are not as effective as the free radicals, e.g., fluorine atoms (F•), in reacting with deposition residues and effecting removal from the process equipment. Therefore, the recombination, i.e., the loss, of free radicals is a main limitation or bottleneck in reactant utilization and in the cleaning speed in remote plasma chamber cleaning.

It has been found that one can suppress the recombination of free radicals into their non-reactive form, particularly fluorine radicals into F₂, by the introduction of a free radical initiator to the plasma generally prior to contact with the unwanted residue or to the CVD chamber or both. Free radical initiators are compounds which form a free radical, i.e., a molecule/atom that has a free electron that is not bound with another atom. The free radical initiator should be a compound that easily generates one or more free radicals via dissociation reaction, or by reaction with recombined free radicals under conditions of remote plasma cleaning. Examples of free radicals include F•, O•, Cl•, Br•, etc. Examples of free radical initiators that can produce such free radicals include O₃ (ozone), halogens such as Cl₂, Br₂, and I₂, interhalogens such as BrF, CIF, IF ; OF, and OF₂.

Illustrative mechanisms for the prevention of recombination of free radicals via the use of free radical initiators by the molecule XY and specific free radical initiators form free radicals per the equations which follow:
1.

   XY → X• + Y
2. Ozone (O₃)

   O₃ → O• + O₂
3. Homonuclear halogen free radical initiator molecules:

   Cl₂ → Cl• + Cl•

   Br₂ → Br• + Br•

   I₂ → I• + I•
4. Interhalogen free radical initiator molecules XₘYₙ where X and Y are two different halogen atoms, and the subscripts m and n are integer numbers 1-7.

   CIF → Cl• + F•

   BrCl → Br• + Cl•

   IBr → I• + Br•
5. Oxyfluorides:

   OF₂ → OF• + F•

   OCl₂ → OCl• + Cl•
6. Polyatomic halides:

   CF₃l → CF₃• + I•

   CF₃Br → CF₃• + Br•

   SF₅Br → SF₅• + Br•

   SF₅I → SF₅• + I•
7. Hypofluorites:

   CF₃OF → CF₃• + FO•

   CF₂(OF)₂ → CF₂(OF) • + FO• → CF₂• + 2 FO•
8. Fluoroperoxides:

   CF₃OOCF₃ → CF₃O• + CF₃O•

   CF₃O• → CF₃• + O•

   CF₃OOF→ CF₃O• + OF•
9. Fluorotrioxides:

   CF₃OOOCF₃ → 2CF₃• + O₂ + O•

The free radicals generated from these free radical initiators can react with fluorine molecules, F₂, to re-generate free fluorine atoms or fluorine radicals per the equation:

X• + F₂ → XF + F• where XF may further dissociate to generate another F• via the equation: XF → X• + F•

Some free radical initiators can directly react with reactant compounds or molecules, e.g., F₂, to regenerate their respective free radical, e.g., fluorine atoms F•. For example, ozone and bromine can react directly with fluorine to generate free radicals per the following equations:

O₃ + F₂ → O₂ + OF• + F•

Br₂ + F₂ → BrF + F•

The free radical initiator can be added over a wide range, although a molar ratio of free radical initiator to reactant is generally from about 0.1:1 to 10:1. Levels in excess of 10:1 have not afforded significant advantages. Typically, one adds the free radical initiator in sufficient proportion to maintain adequate clean rates and reaction efficiency. When the reaction rate or rate of unwanted residue falls below desired levels, one can increase the level of free radical initiator to determine if that was the problem of rate limitation.

To facilitate an understanding of the process for preventing recombination of free radicals in remote plasma cleaning of CVD process chambers and ancillary equipment, reference is made to the drawing.

The drawing shows a CVD process chamber 2 designed for producing a variety of films on various substrates employed in the production of electronic devices. A remote plasma generator 4 is placed upstream of CVD process chamber 2 and communicates with connector 6. A pump 8 is used to pressurize or evacuate CVD process chamber 2 with the effluent being removed from pump 8 via line 10.

In the remote clean process, a reactant, typically NF₃ or other fluorine containing compound 12 is charged to plasma generator 4 via line 16. The flow rate of reactant to the plasma generator 4 typically is from 100 about to 5000 sccm. Often the reactant is mixed with an inert gas, such as nitrogen or argon, to better control the reaction rate and temperatures within the CVD process chamber 2. In this embodiment the mixture consists of 20% NF₃ in argon. The temperature and pressure in the CVD process chamber 2 during a remote plasma clean generally will be from room temperature to 700 °C and from 1 Torr to 760 Torr.

The free radical initiator source, e.g., ozone, is supplied from site 16. Optionally activation energy, such as microwave energy, for the free radical initiator retained in site 16 can be supplied from source 18. The free radical initiators are injected into CVD process chamber 2 generally downstream of remote plasma generator 4. More specifically, the free radical initiators generally are injected into the connector 6 between the remote plasma generator 4 and the CVD process chamber 2 via ports 20 and/or 22. Multiple injection ports are used to optimize the effect of free radical initiators in achieving an increased density of free radicals, such as fluorine radicals (F•), in the CVD process chamber 2 for chamber cleaning processes. Unwanted residue reacts with the fluorine atoms generating a volatile species. This species is removed as effluent via line 10.

Summarizing, by using a free radical initiator to sustain the presence of free radicals such as fluorine atoms (F•) in a CVD process chamber one can enhance the chamber cleaning reactions, reduce clean time, increase production throughput, increase feed gas fluorine utilization, reduce consumption of feed gas, reduce F₂ emission in the effluent, and reduce the load for F₂ effluent abatement. Overall, this invention can result in significant reduction of the cost of ownership (COO) of remote plasma chamber cleaning operation.

## Claims

1. A process for the remote plasma cleaning of a CVD process chamber from unwanted deposition byproducts formed on the walls and surfaces of such process deposition chamber which comprises the steps:
charging a reactant to a plasma generator, said plasma generator located upstream of said CVD process chamber;
forming a plasma comprised of free radicals from said reactant in said plasma generator said plasma capable of reacting with said unwanted deposition products and forming a volatile species therefrom;
providing a free radical initiator capable of forming free radicals;
delivering said plasma and said free radical initiator to said CVD process chamber under conditions for effecting reaction with said unwanted residue and generating a volatile species; and,
removing said volatile species from said CVD process chamber.

2. The process of Claim 1 wherein the free radical initiator is a compound capable of forming a free radical selected from the group consisting of F•, O•, Cl•, and Br•.

3. The process of Claim 2 wherein the reactant is a halogen containing compound.

4. The process of Claim 2 wherein the halogen containing compound is a fluorine containing compound.

5. The process of Claim 4 wherein the fluorine containing compound is selected from the group consisting of fluorine, nitrogen trifluoride, tetrafluoromethane, hexafluoroethane, octafluoropropane, octafluoro-cyclobutane, sulfur hexafluoride, oxydifluoride, and chlorotrifluoride.

6. The process of Claim 2 wherein the unwanted deposition product is selected from tungsten, undoped and doped poly-crystalline silicon, doped and undoped (intrinsic) amorphous silicon; silicon dioxide, undoped silicon glass, boron doped silicon glass, phosphorus doped silicon glass, borophosphorosilicate glass, silicon nitride, silicon oxynitridefluorine doped silicate glass, and carbon-doped silicon glass.

7. The process of Claim 2 wherein the free radical initiator is selected from the group consisting of ozone (O₃), homonuclear halogen free radical initiator molecules, interhalogen free radical initiator molecules, oxyfluorides, polyatomic halides, hypofluorites, fluoroperoxides, and fluorotrioxides,

8. The process of Claim 7 wherein the homonuclear free radical initiator molecules are selected from Cl₂, Br₂, and I₂.

9. The process of Claim 7 wherein the polyatomic halide is of the formula XₘYₙ where X and Y are two different halogen atoms, and the subscripts m and n are integer numbers 1-7.

10. The process of Claim 9 wherein the interhalogen halide is selected from the group consisting of CIF, BrCl, and IBr.

11. The process of Claim 7 wherein the oxyfluoride is selected from the group consisting of OF₂, and OCl₂.

12. The process of Claim 7 wherein the hypofluorite is selected from the group consisting of CF₃OF and CF₂(OF)₂.

13. The process of Claim 7 wherein the fluoroperoxide is selected from the group consisting of CF₃OOCF₃ and CF₃OOF.

14. The process of Claim 7 wherein the fluorotrioxide is CF₃OOOCF₃.

15. The process of Claim 7 wherein the polyatomic halide is selected from the group consisting of CF₃I, CF₃Br, SF₅Br, and SF₅I.

16. A process for the remote plasma cleaning of unwanted deposition residues from a semiconductor deposition process chamber which comprises charging a reactant to a plasma generator, converting the reactant to a plasma, delivering the plasma to the semiconductor deposition process chamber, reacting the plasma with the unwanted residue generating a volatile species, removing the volatile species, and including the step of providing a free radical initiator to the plasma prior to delivery of the plasma to the semiconductor deposition process chamber.

17. The process of Claim 16 which comprises delivering free radical initiator to the semiconductor deposition process chamber.

18. The process of Claim 16 wherein the reactant is NF₃ and the free radical initiator is ozone.
